# EUROPÄISCHE PATENTANMELDUNG

(11) **EP 3 273 459 A1**
(43) Veröffentlichungstag der Anmeldung: **24.01.2018**
(21) Anmeldenummer: 16180761.5
(22) Anmeldetag: 22.07.2016
(51) Int. Cl.: H01H 9/16, H01H 85/30

(54) **EINRICHTUNG UND VERFAHREN ZUR ÜBERWACHUNG EINER UNTERBRECHUNGSEINHEIT IN EINEM ELEKTRISCHEN ENERGIEVERSORGUNGSNETZ SOWIE VERTEILERSTATION MIT EINER ÜBERWACHTEN UNTERBRECHUNGSEINHEIT**

(71) Anmelder: Siemens Aktiengesellschaft, 80333 München (DE)
(72) Erfinder: Fröhner, Wiebke, 92224 Amberg (DE); Werner, Thomas, 91126 Rednitzhembach (DE)

(57) **Zusammenfassung**

Die Erfindung betrifft eine Einrichtung (17) zur Überwachung einer Unterbrechungseinheit (16a, 16b, 16c) in einem elektrischen Energieversorgungsnetz.

Um den Aufwand eines Netzbetreibers zur Erkennung und Lokalisierung von ausgelösten Unterbrechungseinheiten (16a, 16b, 16c) zu verringern, wird vorgeschlagen, dass die Einrichtung (17) eine Sensorschnittstelle (21a) zum Anschluss einer Sensoreinheit (21b) zur Erfassung einer für die Unterbrechereinheit (16a, 16b, 16c) spezifischen Messgröße (M), eine mit der Sensorschnittstelle (21a) in Verbindung stehende Auswerteeinheit (20), die zur Erkennung einer Stromänderung hinsichtlich des durch die Unterbrechungseinheit (16a, 16b, 16c) fließenden Stroms anhand der Messgröße (M) eingerichtet ist, und eine mit der Auswerteeinheit (20) in Verbindung stehende Kommunikationsschnittstelle (22a) aufweist, über die im Falle einer erkannten Stromänderung ein Meldesignal (S), das auf einen kritischen Zustand der Unterbrechereinheit hinweist, an eine Kommunikationseinheit (22b) abgebbar ist.

Die Erfindung betrifft auch ein Verfahren zur Überwachung einer Unterbrechungseinrichtung und eine Verteilerstation mit einer Einrichtung zur Überwachung einer Unterbrechungseinrichtung.

## Beschreibung

Die Erfindung betrifft eine Einrichtung und ein Verfahren zur Überwachung einer Unterbrechungseinheit in einem elektrischen Energieversorgungsnetz. Die Erfindung betrifft auch eine Verteilerstation mit einer überwachten Unterbrechungseinheit.

In vielen öffentlichen Mittel- und Niederspannungsnetzen werden Verteilerstationen, z.B. Ortsnetzstationen oder Kabelverteilerschränke, eingesetzt. Ortsnetzstationen dienen zum Anschluss des Mittelspannungsnetzes an Kabelverteilerschränke im Niederspanungsnetz; Kabelverteilerschränke sind dazu vorgesehen, um die Netzanschlüsse der einzelnen Endeverbraucher (Haushalte, Büros, Gewerbe, kleine Industrie) mit einer zugehörigen Ortsnetzstation zu verbinden. Von der Ortnetzstation führt hierbei zunächst ein Kabel zum Kabelverteilerschrank. Dort befinden sich eine oder mehrere Sammelschienen, an denen die einzelnen Leitungsabzweige angeschlossen sind, die zu den jeweiligen Netzanschlüssen führen.

Die Sammelschienen und/oder die einzelnen Abzweige in solchen Verteilerstationen sind üblicherweise mit NH-Sicherungen (NH-Sicherung = Niederspanungs-Hochleistungs-Sicherung) oder elektromechanisch ausgelösten Schaltgeräten geschützt, um den Abzweig vor thermischen Überlastungen oder vor Kurzschlüssen zu schützen. Bei den NH-Sicherungen handelt es sich oftmals um Schmelzsicherungen. Im Folgenden werden Sicherungen (inklusive NH-Sicherungen) und elektromechanisch ausgelöste Schaltgeräte auch als "Unterbrechungseinheiten" bezeichnet.

Diese Unterbrechereinheiten in Verteilerstationen werden heute im Allgemeinen nicht aus der Ferne überwacht. Die fehlende Fernüberwachung führt dazu, dass der Prozess der Fehlererkennung und Fehlerlokalisierung im Mittel- und Niederspannungsnetz zeitlich und personell aufwendig ist.

Beispielsweise ist der Netzbetreiber eines Niederspannungsnetzes nämlich zunächst darauf angewiesen, dass er von seinen Kunden, beispielsweise telefonisch, auf einen Stromausfall hingewiesen wird. Die Ursache für den Stromausfall kann hierbei allerdings sowohl im öffentlichen Netz als auch in der Kundenanlage liegen. Daher muss der Netzbetreiber zunächst einige Kundenhinweise abwarten, um Sicherheit darüber zu erlangen, ob die Ursache des Stromausfalls tatsächlich in seinem Netz liegt. Mit Hilfe der Adressinformation der Kunden kann er daraufhin auf das Netzsegment zurückschließen, in dem der Fehler vermutlich liegt. Im Anschluss daran benachrichtigt der Netzbetreiber eine Wartungsmannschaft, die die ausgelöste Unterbrechungseinheit auffinden muss. Die Wartungsmannschaft fährt die in Frage kommenden Kabelverteilerschränke ab und prüft optisch, ob eine der im Kabelverteilerschrank eingebauten Sicherungen ausgelöst hat. Dazu dient ein optischer Indikator der Sicherung.

Eine optische Zustandsanzeige für NH-Sicherungen ist beispielsweise aus der WO 2011/114176 A1 bekannt. Aus der EP 1 271 583 A2 ist eine in einem Kabelverteilerschrank zu montierende Sicherungsleiste für NH-Sicherungen bekannt. Die EP 0 068 490 A2 zeigt schließlich einen Kabelverteilerschrank mit NH-Sicherungen, der einen besonders platzsparenden Aufbau besitzt. Eine Ortsnetzstation in einem Mittelspannungsnetz ist zudem beispielsweise aus der WO 2014201475 A1 bekannt.

Der Erfindung liegt die Aufgabe zugrunde, den Aufwand eines Netzbetreibers zur Erkennung und Lokalisierung von ausgelösten Unterbrechungseinheiten zu verringern.

Diese Aufgabe wird durch eine Einrichtung zur Überwachung einer Unterbrechungseinheit in einem elektrischen Energieversorgungsnetz gelöst, die eine Sensorschnittstelle zum Anschluss einer Sensoreinheit zur Erfassung einer für die Unterbrechereinheit spezifischen Messgröße, eine mit der Sensorschnittstelle in Verbindung stehende Auswerteeinheit, die zur Erkennung einer Stromänderung hinsichtlich des durch die Unterbrechungseinheit fließenden Stroms anhand der Messgröße eingerichtet ist, und eine mit der Auswerteeinheit in Verbindung stehende Kommunikationsschnittstelle aufweist, über die im Falle einer erkannten Stromänderung ein Meldesignal, das auf einen kritischen Zustand der Unterbrechereinheit hinweist, an eine Kommunikationseinheit abgebbar ist.

Die Erfindung beruht auf der Erkenntnis, dass Unterbrechereinheiten, z.B. Schmelzsicherungen, im Wesentlichen aus zwei Gründen auslösen: bei langandauernden Strömen, die zu thermischen Überlastungen der Leitungen führen, oder bei Kurzschlüssen. Beide Ereignisse gehen mit durch die Unterbrechereinheiten fließenden Strömen einher, die sich schnell und deutlich ändern. Entweder führt hierbei eine schnelle Änderung, wie bei einem Kurzschluss, zum Auslösen der Unterbrechungseinheit oder sie ergibt sich aus dem Auslösen der Unterbrechungseinheit selbst, da durch die Stromunterbrechung eine plötzliche Stromänderung eintritt. Daher ist es zur Überwachung einer Unterbrechungseinheit notwendig, eine solche schnelle Stromänderung zu detektieren und daraus auf eine (demnächst auslösende bzw. bereits ausgelöste) Unterbrechungseinheit zu schließen. Zur Erkennung einer Stromänderung, die auf ein Auslösen der Unterbrechungseinheit hindeutet, kann die Messgröße z.B. mit einem oder mehreren Schwellenwerten verglichen werden oder es können bestimmte Muster im Verlauf der Messgröße ausgewertet und erkannt werden.

Ein besonderer Vorteil der Erfindung besteht darin, dass mit der erfindungsgemäßen Einrichtung eine Überwachung von Unterbrechungseinheiten aus der Ferne ermöglicht wird. Damit können ausgelöste Unterbrechungseinheiten sofort erkannt und der Aufwand bei der Fehlerlokalisierung deutlich reduziert werden. Neben den Kostenvorteilen (z.B. durch eine geringere Einsatzzeit der Wartungsmannschaften) ergibt sich damit auch eine Reduktion der Ausfallzeit der Stromversorgung. In regulierten Energienetzen wird häufig die Ausfallzeit (sogenannter "SAIDI-Index") als Qualitätskriterium verwendet und dem Netzbetreiber gegenüber entsprechend pönalisiert oder belohnt, so dass die Fernüberwachung einen weiteren wirtschaftlichen Vorteil für den Netzbetreiber bietet.

Die Sensoreinheit und die Kommunikationseinheit können separate Einheiten bilden und über die jeweiligen Schnittstellen mit der Auswerteeinheit verbunden sein. In diesem Fall kann die Sensoreinheit als Sonde ausgebildet sein, die angeeigneter Stelle in der Verteilerstation montiert wird, um die Messgröße zu erfassen.

Als kritischer Zustand der Unterbrechungseinheit wird vorliegend insbesondere ein Zustand nach dem Auslösen der Unterbrechungseinheit angesehen (z.B. bei einer Schmelzsicherung nach dem Durchschmelzen des Schmelzleiters), bei dem die Unterbrechungseinheit den Stromfluss dauerhaft unterbricht.

Gemäß einer vorteilhaften Ausführungsform der erfindungsgemäßen Einrichtung ist vorgesehen, dass mit der Sensorschnittstelle eine Sensoreinheit zur Erfassung der Messgröße verbunden ist und die Auswerteeinheit und die Sensoreinheit in einem gemeinsamen Gehäuse angeordnet sind.

Gemäß dieser vorteilhaften Ausführungsform ist die Sensoreinheit in die Einrichtung integriert. Die Sensorschnittstelle stellt in diesem Fall eine interne Schnittstelle dar, die die Sensoreinheit mit der Auswerteeinheit verbindet.

In diesem Zusammenhang kann konkret vorgesehen sein, dass die Sensoreinheit einen Hall-Sensor umfasst. Ein Hall-Sensor dient zur Erfassung eines Magnetfeldes und ist als solcher dem Fachmann bekannt. Ein Hall-Sensor gibt ein Spannungssignal ab, anhand dessen sich auf die Stärke des Magnetfeldes schließen lässt. Da ein durch einen Leiter fließender Strom ein mit dem Hall-Sensor detektierbares Magnetfeld erzeugt, kann durch Auswertung des Ausgangssignals des Hall-Sensors auf eine Änderung des Magnetfeldes geschlossen werden. Eine Änderung des Magnetfeldes bedeutet schließlich eine Änderung des Stromflusses durch die Unterbrechungseinheit, so dass anhand der mittels des Hall-Sensors erfassten Messgröße eine Änderung des Stromes durch die Unterbrechungseinheit erkannt werden kann. Dieser konkreten Ausführungsform liegt somit die Erkenntnis zugrunde, dass sich eine schnelle Stromänderung mit Hilfe einer Messung des Magnetfelds detektieren lässt.

Ein weiterer Vorteil des Einsatzes eines Hall-Sensors ist dessen geringe Baugröße. Insbesondere in Kabelverteilerschränken, aber auch teilweise in Ortsnetzstationen, steht üblicherweise nur begrenzter Raum für weitere Einbauten zur Verfügung, so dass auf eine geringe Baugröße der Einrichtung zur Überwachung der Unterbrechungseinheiten zu achten ist.

Ein weiterer Vorteil der Überwachung des Magnetfeldes liegt darin, dass es zur prinzipiellen Erkennung, in welcher der Verteilerstationen eine Unterbrechungseinheit ausgelöst hat, ausreicht, die Änderung des gesamten Magnetfelds innerhalb der Verteilerstation zu überwachen. Eine auf den einzelnen Abzweig bezogene Überwachung ist nicht notwendig, da die Wartungsmannschaft nach Identifizierung der fraglichen Verteilerstation die ausgelöste Unterbrechungseinheit sehr leicht durch Inaugenscheinnahme erkennen kann.

Gemäß einer anderen vorteilhaften Ausführungsform kann jedoch auch vorgesehen sein, dass die Sensoreinheit einen Stromsensor umfasst.

Als Stromsensor kommt dabei sowohl ein herkömmlicher induktiver Wandler (z.B. Ringkernwandler) als auch ein sogenannter nichtkonventioneller Wandler (z.B. Rogowski-Spule) in Frage.

Die konkrete Auswahl des Sensors ist letztlich vom zur Verfügung stehenden Platz in der Verteilerstation und von den Kosten für die Anschaffung und Montage der Sensoren abhängig.

Eine weitere vorteilhafte Ausführungsform der erfindungsgemäßen Einrichtung besteht darin, dass mit der Kommunikationsschnittstelle eine Kommunikationseinheit verbunden ist und die Auswerteeinheit und die Kommunikationseinheit in einem gemeinsamen Gehäuse angeordnet sind.

Gemäß dieser vorteilhaften Ausführungsform ist die Kommunikationseinheit in die Einrichtung integriert. Die Kommunikationsschnittstelle stellt in diesem Fall eine interne Schnittstelle dar, die die Kommunikationseinheit mit der Auswerteeinheit verbindet.

Konkret kann in diesem Zusammenhang vorgesehen sein, dass die Kommunikationseinheit ein Funkmodul ist.

Diese Ausführungsform hat den Vorteil, dass keine dedizierten Kommunikationsleitungen mit dem Kabelverteilerschrank verbunden werden müssen. Ein Funkmodul kann beispielsweise ein GSM-Modul, ein GPRS-Modul, ein UMTS-Modul, ein LoRaWAN-Modul (Low Range Wide Area Network), ein Narrow Band IoT-Modul (Internet of Things) oder ähnliches sein.

In diesem Zusammenhang wird es zudem als vorteilhaft angesehen, wenn die Einrichtung einen Anschluss zur Verbindung mit einer Funkantenne aufweist.

Die Funkantenne kann hierbei außen an der Verteilerstation montiert sein. Bei entsprechend funkwellendurchlässigem Material der Verteilerstation (z.B. einem Kabelverteilerschrank aus glasfaserverstärkten Polyester) kann jedoch auch eine interne Antenne verwendet werden. Diese kann auch in der Einrichtung integriert sein.

Sollte die Verteilerstation ohnehin mit einer kabelgebundenen Kommunikationsverbindung (z.B. eine Ethernet IP-Verbindung) ausgerüstet sein, so kann diese natürlich auch zur Übermittlung des Meldesignals eingesetzt werden.

Zur Stromversorgung der Einrichtung kann eine externe Stromversorgung vorgesehen sein, die durch die stromführenden Leitungen der Verteilerstation selbst oder durch elektrische Hilfsenergie für Installationen in der Verteilerstation gespeist wird. Es ist zudem auch denkbar, die Einrichtung mit einer Batterie zu versehen und vollständig auf eine externe Stromversorgung zu verzichten.

Eine weitere vorteilhafte Ausführungsform der erfindungsgemäßen Einrichtung sieht vor, dass die Einrichtung mit einem maschinenlesbaren Code versehen ist, der eine eindeutige Identifizierung der Einrichtung angibt.

Hierdurch kann eine vereinfachte Installationsprozedur der Einrichtung in ein übergeordnetes Überwachungssystem unterstützt werden. Der maschinenlesbare Code kann beispielsweise ein Barcode, ein QR-Code (QR = Quick Response) oder eine Folge von alphanumerischen Zeichen (z.B. eine Seriennummer) sein. Bei der Montage der Einrichtung in der Verteilerstation kann dieser Code mittels einer geeigneten Leseeinrichtung (z.B. Scanner, Smartphone etc.) eingelesen und ausgewertet werden. Die Identifizierungsinformation der Einrichtung kann dann an ein übergeordnetes Überwachungssystem übermittelt werden, um die Einrichtung der konkreten Verteilerstation zuzuordnen. Hierzu können zusätzlich Ortsdaten erfasst werden, die den geografischen Ort (Geokoordinaten) und/oder den topologischen Ort (Knotenpunkt im Energienetz) angeben, an dem die Verteilerstation aufgestellt ist, um der Wartungsmannschaft die Ortung der ausgefallen Unterbrechungseinheit zu erleichtern.

Die Identifizierungsinformation und ggf. die Ortsinformation werden an das übergeordnete Überwachungssystem übermittelt und dort gespeichert.

Die oben genannte Aufgabe wird auch durch ein Verfahren zum Überwachen einer Unterbrechungseinheit in einem elektrischen Energieversorgungsnetz mit einer Einrichtung gemäß einem der Ansprüche 1 bis 8 gelöst. Erfindungsgemäß wird bei dem Verfahren mit einer der Einrichtung zugeordneten Sensoreinheit eine für die Unterbrechungseinheit spezifische Messgröße erfasst, mit einer Auswerteeinheit der Einrichtung die Messgröße hinsichtlich des Auftretens einer Stromänderung des durch die Unterbrechungseinheit fließenden Stroms untersucht und bei vorliegender Stromänderung mittels einer der Einrichtung zugeordneten Kommunikationseinheit ein Meldesignal abgegeben, das auf einen kritischen Zustand der Unterbrechungseinheit hinweist.

Auf diese Weise kann besonders vorteilhaft eine Fernüberwachung einer Unterbrechungseinheit eines Energieversorgungsnetzes erfolgen.

Hinsichtlich des erfindungsgemäßen Verfahrens gelten alle zu der erfindungsgemäßen Einrichtung voranstehend und nachfolgend gemachten Ausführungen und umgekehrt in entsprechender Weise, insbesondere ist die erfindungsgemäße Einrichtung zur Durchführung des erfindungsgemäßen Verfahrens in jeder beliebigen Ausführungsform oder einer Kombination beliebiger Ausführungsformen eingerichtet. Auch hinsichtlich der Vorteile des erfindungsgemäßen Verfahrens wird auf die zu der erfindungsgemäßen Einrichtung beschriebenen Vorteile und umgekehrt verwiesen.

Gemäß einer vorteilhaften Ausführungsform des erfindungsgemäßen Verfahrens kann vorgesehen sein, dass vor der Inbetriebnahme die Einrichtung diese in einer Verteilerstation (z.B. einem Kabelverteilerschrank oder einer Ortsnetzstation) montiert wird.

Hierdurch kann besonders effektiv eine Überwachung der Unterbrechungseinheiten direkt in der Nähe ihres Einbauortes erfolgen. Bei geeigneter Ausführung der Einrichtung, insbesondere bei Verwendung eines Hall-Sensors zur Messung des Magnetfeldes im Bereich der Unterbrechungseinheiten, ist zudem eine einzelne Einrichtung zur Überwachung aller in der Verteilerstation vorhandenen Unterbrechungseinheiten ausreichend, da hierbei eine Messung hinsichtlich des Gesamtmagnetfeldes in der Verteilerstation durchgeführt werden kann, anstelle pro Abzweig eine oder mehrere Messungen durchführen zu müssen.

Gemäß einer vorteilhaften Ausführungsform kann in diesem Zusammenhang vorgesehen sein, dass bei der Montage ein maschinenlesbarer Code erfasst wird, der eine Identifizierungsinformationen enthält, die eine eindeutige Identifizierung der Einrichtung ermöglicht.

Hierdurch kann die Erfassung der Einrichtung in einem übergeordneten Überwachungssystem, z.B. einem Netzleitsystem oder einem Cloudservice, vereinfacht werden. Der die Einrichtung in der Verteilerstation montierende Techniker kann in diesem Fall durch einfaches Einlesen des maschinenlesbaren Codes (Barcode, QR-Code,...), beispielsweise mittels einer Kamera eines Smartphones oder mit einem dedizierten Scanner, den Code einlesen und daraus die Identifizierungsinformation der Einrichtung ermitteln. Diese kann daraufhin an das übergeordnete Überwachungssystem gesendet werden, um die Einrichtung anzumelden. Auf diese Weise erübrigen sich weitgehend manuelle Konfigurationshandlungen.

In diesem Zusammenhang wird es zudem als vorteilhaft angesehen, wenn der Identifizierungsinformation eine Ortsinformation zugeordnet wird, die den geografischen und/oder topologischen Ort der Verteilerstation angibt.

Auf diese Weise kann die Anmeldung der Einrichtung in einem übergeordneten Überwachungssystem noch weiter vereinfacht werden, da zusätzlich zu der Identifizierung der Einrichtung auch ihr Einbauort, geografisch und/oder topologisch, erfasst wird. Die Erfassung der Ortsinformation kann beispielsweise durch einen GPS-Empfänger (z.B. integriert in dem Smartphone, das zum Einlesen des Codes verwendet wird) oder durch Einlesen eines an der Verteilerstation angebrachten Codes, der die Ortsinformation enthält, erfolgen. Auch eine manuelle Eingabe der Ortsinformation durch den Techniker ist möglich.

Die oben genannte Aufgabe wird schließlich auch durch eine Verteilerstation mit einer überwachten Unterbrechungseinheit und einer Einrichtung nach einem der Ansprüche 1 bis 8 gelöst.

Hinsichtlich der erfindungsgemäßen Verteilerstation gelten alle zu der erfindungsgemäßen Einrichtung voranstehend und nachfolgend gemachten Ausführungen und umgekehrt in entsprechender Weise. Auch hinsichtlich der Vorteile der erfindungsgemäßen Verteilerstation wird auf die zu der erfindungsgemäßen Einrichtung beschriebenen Vorteile und umgekehrt verwiesen.

Gemäß einer vorteilhaften Ausführungsform der erfindungsgemäßen Verteilerstation kann vorgesehen sein, dass in der Verteilerstation eine Mehrzahl von Unterbrechungseinheiten und eine einzige Einrichtung zur Überwachung der Mehrzahl von Unterbrechungseinheiten angeordnet sind.

Bei geeigneter Ausführung der Einrichtung, insbesondere bei Verwendung eines Hall-Sensors zur Messung des Magnetfeldes im Bereich der Unterbrechungseinheiten, ist es nämlich möglich, mit einer einzelnen Einrichtung alle in der Verteilerstation vorhandenen Unterbrechungseinheiten zu überwachen, da hierbei eine Messung hinsichtlich des Gesamtmagnetfeldes in der Verteilerstation durchgeführt werden kann, anstelle pro Abzweig eine oder mehrere Messungen durchführen zu müssen.

Gemäß einer weiteren vorteilhaften Ausführungsform der erfindungsgemäßen Verteilerstation kann schließlich vorgesehen sein, dass die Unterbrechungseinheit eine Schmelzsicherung oder ein elektromechanisch auslösender Schalter ist.

Die Erfindung wird nachfolgend anhand eines Ausführungsbeispiels näher erläutert. Die spezifische Ausgestaltung des Ausführungsbeispiels ist für die allgemeine Ausgestaltung des erfindungsgemäßen Verfahrens und der erfindungsgemäßen Einrichtung in keiner Weise einschränkend zu verstehen; vielmehr können einzelne Ausgestaltungsmerkmale des Ausführungsbeispiels in beliebiger Weise frei untereinander und mit den voranstehend beschriebenen Merkmalen kombiniert werden.

Hierzu zeigen
- Figur 1: eine schematische Ansicht eines Kabelverteilerschranks in einem elektrischen Niederspannungsnetz;
- Figur 2: eine schematische Ansicht eines ersten Ausführungsbeispiels einer Einrichtung zur Überwachung einer Unterbrechungseinheit;
- Figur 3: eine schematische Ansicht eines zweiten Ausführungsbeispiels einer Einrichtung zur Überwachung einer Unterbrechungseinheit; und
- Figur 4: ein Verfahrensfließbild zur Erläuterung der Anmeldung einer Einrichtung zur Überwachung einer Unterbrechungseinheit in einem übergeordneten Überwachungssystem.

Die nachfolgenden Erläuterungen beziehen sich lediglich beispielhaft auf eine Einrichtung zur Überwachung einer Unterbrechungseinheit in einer Verteilerstation in Form eines Kabelverteilerschranks in einem Niederspanungsnetz. Die Ausführungen können jedoch entsprechend auf eine Ortsnetzstation in einem Mittelspanungsnetz übertragen werden.

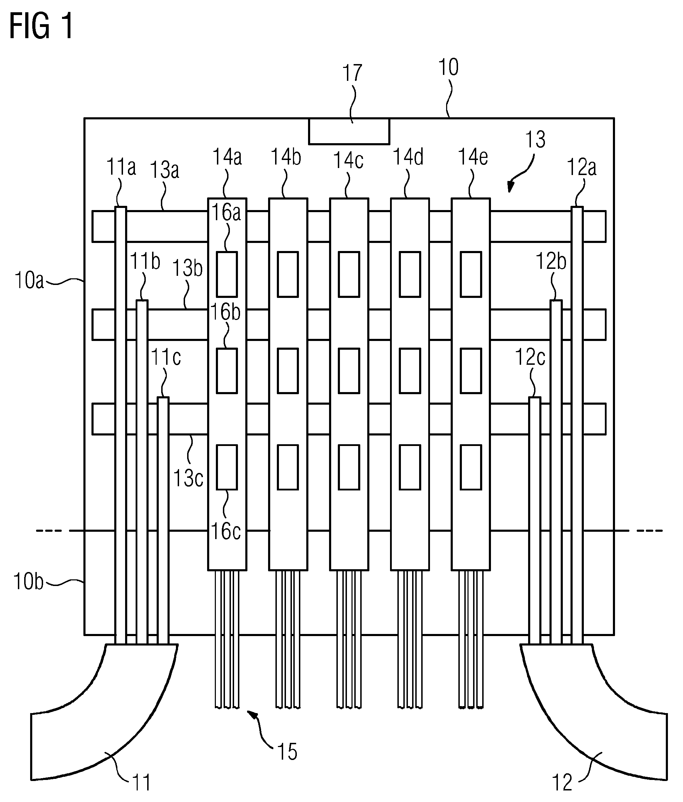

Figur 1 zeigt in schematischer Ansicht eine Verteilerstation 10 in Form eines Kabelverteilerschranks eines elektrischen Niederspanungsnetzes. Der Kabelverteilerschrank weist einen oberirdisch angeordneten Schrankteil 10a und einen im Boden eingelassenen Sockelteil 10b auf. Ein erstes dreiphasiges Erdkabel 11 wird von unten in den Kabelverteilerschrank hinein geführt. Die einzelnen Phasen 11a, 11b, 11c des Erdkabels 11 sind im Kabelverteilerschrank mit unterschiedlichen Leitern 13a, 13b, 13c einer Sammelschiene 13 verbunden. Das erste Erdkabel 11 dient beispielsweise dazu, eine in Figur 1 nicht gezeigte Ortsnetzstation elektrisch mit dem Kabelverteilerschrank zu verbinden.

Ein zweites dreiphasiges Erdkabel 12 ist mit seinen einzelnen Phasen 12a, 12b, 12c mit den jeweiligen Leitern 13a, 13b, 13c der Sammelschiene 13 verbunden und dient zur elektrischen Verbindung des Kabelverteilerschranks mit einem weiteren, in Figur 1 nicht gezeigten, Kabelverteilerschrank.

Mit den einzelnen Leitern 13a, 13b, 13c der Sammelschiene 13 sind Abzweige 14a-e verbunden. Diese Abzweige dienen dazu, den Kabelverteilerschrank elektrisch mit Endverbrauchern (z.B. Haushalten, Gewerbe, Büros, kleiner Industrie) zu verbinden. Dazu werden die einzelnen Leiter 13a, 13b, 13c der Sammelschiene 13 auf Abzweigleitungen 15 (beispielhaft nur für den Abzweig 14a gezeigt) geführt. Die Abzweigleitungen 15 führen zu in der Nähe des Kabelverteilerschranks gelegenen Endverbrauchern.

Um die Abzweigleitungen 15 vor thermischer Überlast aufgrund von Kurzschlüssen oder langandauernden hohen Strömen zu schützen, sind die Abzweige 14a-e mit Unterbrechungseinheiten 16a, 16b, 16c versehen (beispielhaft nur für den Abzweig 14a gezeigt), bei denen es sich beispielsweise um NH-Schmelzsicherungen handeln kann. Diese Unterbrechungseinheiten 16a, 16b, 16c unterbrechen den Stromfluss durch die Abzweige im Überlastfall dauerhaft und müssen zur Wiederherstellung der Stromversorgung von einer Wartungsmannschaft ausgetauscht werden.

Hierzu ist es vonnöten, dass die Wartungsmannschaft die ausgelöste Unterbrechungseinheit 16a, 16b, 16c möglichst schnell findet. Innerhalb des Kabelverteilerschranks lässt sich die ausgelöste Unterbrechungseinheit vergleichsweise schnell durch optische Inaugenscheinnahme identifizieren, die Ermittlung des betroffenen Kabelverteilerschranks ist hingegen mit erheblich höherem Aufwand verbunden.

Um eine Fernüberwachung der Unterbrechungseinheiten 16a, 16b, 16c zu ermöglichen und damit die Erkennung des betroffenen Kabelverteilerschranks zu erleichtern, wird eine Einrichtung 17 zur Überwachung einer (oder mehrerer) Unterbrechungseinheit(en) eingesetzt.

Die Einrichtung 17 führt hierzu die Auswertung einer für die Unterbrechungseinheit spezifischen Messgröße durch, um anhand der Messgröße auf eine etwaige sprunghafte Änderung des Stromflusses durch den Abzweig (und damit durch die Unterbrechungseinheit) schließen zu können.

Wird eine solche sprunghafte Stromänderung erkannt, so kann davon ausgegangen werden, dass die Unterbrechungseinheit in Kürze auslösen wird oder bereits ausgelöst hat, um den Stromfluss zum Schutz des Abzweigs zu unterbrechen. Daher gibt die Einrichtung 17 beim Erkennen einer sprunghaften Stromänderung ein Meldesignal an ein in Figur 1 nicht gezeigtes übergeordnetes Überwachungssystem ab, um den Netzbetreiber des Niederspanungsnetzes auf die Überlastsituation hinzuweisen.

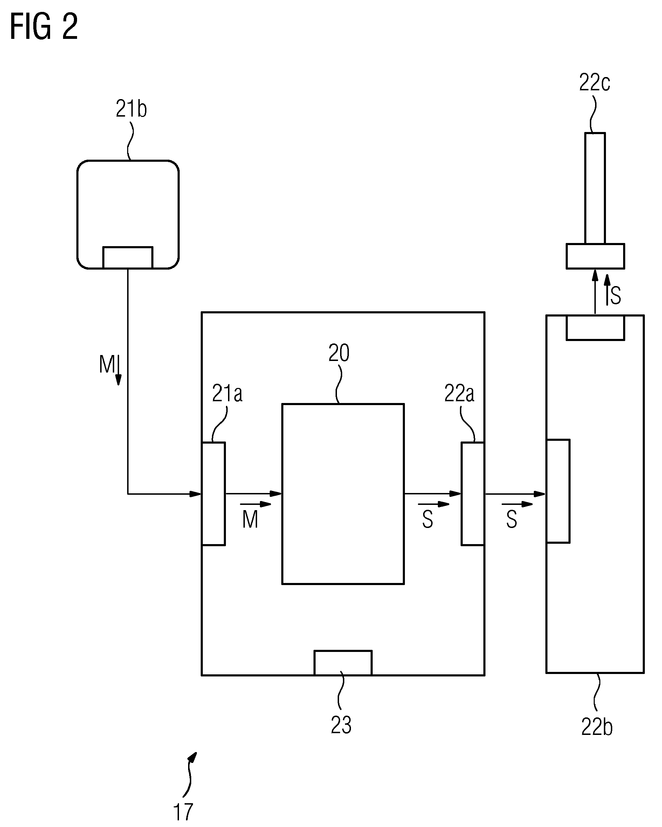

Ein erstes Ausführungsbeispiel einer Einrichtung 17 ist in Figur 2 beispielhaft dargestellt.

Die in Figur 2 gezeigte Einrichtung weist eine Auswerteeinheit 20 auf, die zur Untersuchung einer für die Unterbrechungseinheit spezifischen Messgröße M eingerichtet ist, um daran auf eine sprunghafte Änderung des durch die Unterbrechungseinheit fließenden Stromes schließen zu können. Die Messgröße M kann z.B. den Strom durch die Unterbrechungseinheit direkt angeben. Sie kann aber auch eine indirekt von dem Stromfluss abhängige Messgröße, z.B. eine Magnetfeldstärke, sein.

Zur Erfassung der Messgröße M ist die Auswerteeinheit 20 über eine Sensorschnittstelle 21a mit einer Sensoreinheit 21b verbunden, bei der es sich z.B. um einen Hall-Sensor handeln kann. Mit einem Hall-Sensor kann eine Magnetfeldstärke gemessen werden. Ein Sprung im Stromfluss durch eine Unterbrechungseinheit ist aufgrund der Wechselbeziehung zwischen elektrischem und magnetischem Feld mit einer sprunghaften Änderung des Magnetfeldes verbunden, die durch Auswertung der mit dem Hall-Sensor aufgenommenen Messgröße M durch die Auswerteeinheit 20 erkannt werden kann.

Um im Falle einer erkannten sprunghaften Stromänderung den Netzbetreiber informieren zu können, ist die Auswerteeinheit 20 über eine Kommunikationsschnittstelle 22a mit einer Kommunikationseinheit 22b (beispielsweise einem Mobilfunkmodul) verbunden. Im Falle einer erkannten sprunghaften Stromänderung gibt die Auswerteeinheit 20 über die Kommunikationsschnittstelle 22a ein Meldesignal S an die Kommunikationseinheit 22b ab.

Über eine mit der Kommunikationseinheit 22b in Verbindung stehende Mobilfunkantenne 22c kann das Meldesignal als Funksignal an das übergeordnete Überwachungssystem übertragen werden.

Die Stromversorgung der Einrichtung 17 erfolgt im Beispiel der Figur 2 über den Stromanschluss 23 aus einer externen Stromversorgungseinheit, die z.B. aus einem Hilfsstromkreis des Kabelverteilerschranks 10 gespeist wird.

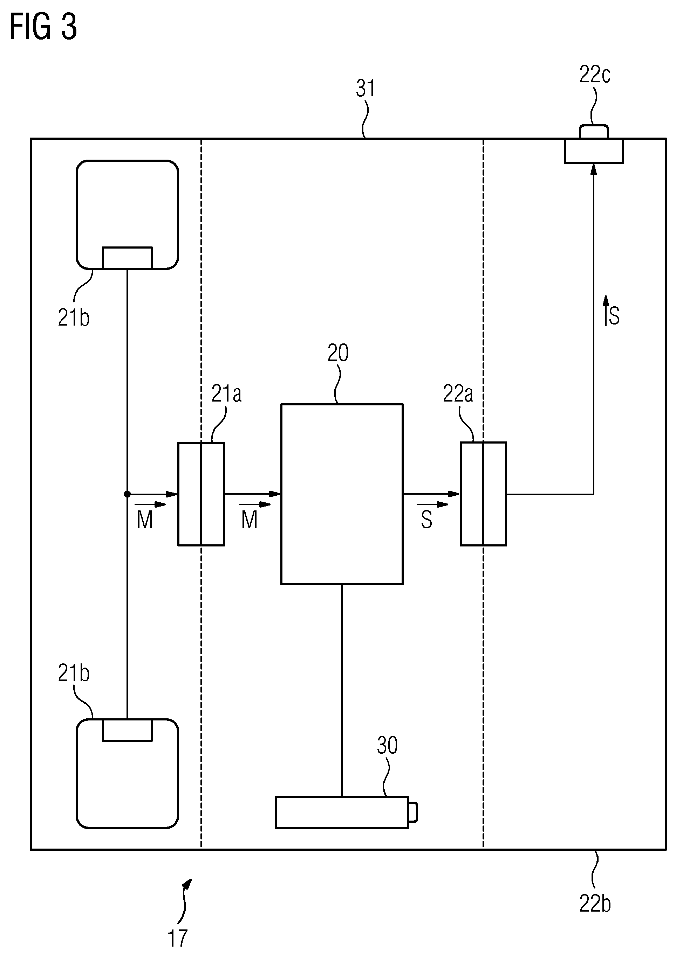

Figur 3 zeigt ein zweites Ausführungsbeispiel einer Einrichtung 17 zur Überwachung von Unterbrechungseinheiten. Einander entsprechende Elemente in Figuren 2 und 3 sind mit denselben Bezugszeichen gekennzeichnet.

So weist auch die Einrichtung 17 gemäß Figur 3 eine Auswerteeinheit 20 auf, die über eine Sensorschnittstelle 21a mit einer Sensoreinheit 21b und über eine Kommunikationsschnittstelle 22a mit einer Kommunikationseinheit 22b (mit Mobilfunkantenne 22c) verbunden ist. Die Funktionsweise der Einrichtung 17 gemäß Figur 2 entspricht derjenigen gemäß Figur 2, so dass an dieser Stelle auf eine bloße Wiederholung verzichtet wird.

Während es sich bei der Einrichtung 17 gemäß Figur 2 um eine modular aufgebaute Einrichtung handelt, bei der Auswerteeinheit 20, Sensoreinheit 21b und Kommunikationseinheit 22b auf getrennten Baugruppen angeordnet sind, stellt die Einrichtung 17 gemäß Figur 3 eine integrierte Einrichtung dar, bei der Auswerteeinheit 20, Sensoreinheit 21b und Kommunikationseinheit 22b in einem gemeinsamen Gehäuse 31 (und ggf. auf einer gemeinsamen Baugruppe) angeordnet sind.

Die Einrichtung 17 gemäß Figur 3 weist zudem eine integrierte Mobilfunkantenne 22c auf.

Die Stromversorgung der Einrichtung 17 gemäß Figur 3 erfolgt im Unterschied zur Einrichtung 17 gemäß Figur 2 über eine in die Einrichtung 17 eingesetzte Batterie 30.

Außer den in Figuren 2 und 3 gezeigten Ausführungen ist auch eine gemischte Bauweise denkbar, bei der beispielsweise die Kommunikationseinheit 22b wie in Figur 3 mit der Auswerteeinheit 20 in einem gemeinsamen Gehäuse angeordnet ist, während die Sensoreinheit 21b wie in Figur 2 als separate Sonde ausgestaltet ist.

Wie bereits erläutert ist die Einrichtung 17 dazu ausgebildet eine schnelle Stromänderung zu erkennen, die üblicherweise zu einem Auslösen der entsprechenden Unterbrechungseinheit führt oder durch ein Auslösen der Unterbrechungseinheit verursacht ist.

Prinzipiell können dazu technische Ansätze gewählt werden, wie sie beispielsweise auch bei sogenannten Fehlerstromanzeigern für Freileitungen in Mittelspannungsnetzen eingesetzt werden. Dabei werden ringförmig aufgebaute induktive Stromwandler um die Leitung montiert und mit dem Auswertegerät verbunden. Für den Einsatz insbesondere in Kabelverteilerschränken der Niederspannung ist dieser Aufbau aus folgenden Gründen nur bedingt geeignet:
Häufig ist der Raum in existierenden Kabelverteilerschränken sehr knapp bemessen, so dass der Platz für Einsatz von separaten Geräten für die Erfassung und Kommunikation sowie der Sensoren nicht ausreicht. Damit können solche Kombinationen mit vergleichsweise großen induktiven Stromwandlern nur dann eingesetzt werden, wenn der bisherige Kabelverteilerschrank ausgetauscht wird. In Ortsnetzstationen mit üblicherweise größerem zur Verfügung stehendem Raum können solche induktiven Stromwandler prinzipiell eher eingesetzt werden.

Netzbetreiber verfügen zudem über eine große Anzahl von Verteilerstationen. Selbst bei kleineren Netzbetreibern kommen einige tausend Verteilerstationen zusammen. Damit sind auch die Kosten für die Montage und Inbetriebsetzung einer Überwachungseinrichtung für die Wirtschaftlichkeit bedeutsam.

Daher wird es als besonders vorteilhaft angesehen, wenn anstelle der üblichen Stromsensoren Hall-Sensoren eingesetzt werden, um die Änderungen des Magnetfeldes zu detektieren. Dabei muss nicht die Änderung des Magnetfeldes eines einzelnen Abzweigs überwacht werden, sondern es werden vielmehr die Änderungen der Magnetfelder aller vorhandenen Abzweige innerhalb der Verteilerstation überwacht, die zu einer Änderung des gesamten Magnetfelds in der Verteilerstation beitragen.

Die Hall-Sensoren werden dabei entweder in einer Sonde untergebracht (Figur 2) oder direkt in die Einrichtung integriert (Figur 3).

Für den in vorliegenden Anwendungsfall reicht es nämlich vollkommen aus, zu wissen, in welcher Verteilerstation eine Unterbrechungseinheit ausgelöst hat. Es ist nicht notwendig, den einzelnen Abzweig individuell zu bestimmen.

Dazu weist die Einrichtung 17 die Auswerteeinheit 20 auf, die dazu dient, anhand der mittels der Sensoreinheit 21b erfassten Messgröße M in Form einer Magnetfeldstärke Änderungen des Magnetfeldes zu analysieren und zu erkennen, ob diese Änderungen durch Stromänderungen verursacht wurden, die zum Ansprechen einer Unterbrechungseinheit geführt haben oder die sich aus diesem Ansprechen ergeben haben.

Dazu misst die Auswerteeinheit 20 in sehr kurzen Zeitzyklen mit Hilfe der Sensor-Einheit 21b das Magnetfeld im Inneren der Verteilerstation 10 und prüft, ob die zeitlichen Veränderungen der Ausgangsspannung der Hall-Sensoren zu denen passen, die auf eine Auslösung der Unterbrechungseinheit hindeuten.

Zur Detektion können z.B. elektronische Filter, die das Frequenzspektrum des Ausgangssignals auswerten, oder künstliche neuronal Netze eingesetzt werden, die in abgetasteten Spannungswerten der Hallsensoren nach Mustern suchen.

Die Einrichtung 17 wirkt mit einem Kommunikationsmodul 22b zusammen, das im Falle eines erkannten Auslösens der Unterbrechungseinheit ein Meldesignal an ein übergeordnetes Überwachungssystem abgibt, zum Beispiel an ein Netzleitsystem oder eine Cloud-Plattform.

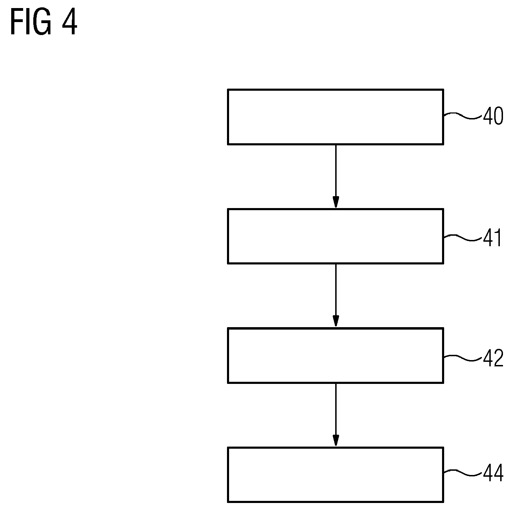

Die Einrichtung kann vorteilhafterweise als Plug-and-Play-Gerät ausgestaltet werden. Dies wird in Figur 4 näher erläutert. Hierzu wird auf die Einrichtung 17 ein maschinenlesbarer Code, beispielsweise ein QR-Code, aufgebracht (z.B. aufgedruckt), der vom Techniker bei der Inbetriebsetzung, z.B. per Smartphone, als die Einrichtung eindeutig kennzeichnende Identifikationsinformation (z.B. eine Seriennummer) eingelesen wird (Schritt 40).

Mit Hilfe z.B. der Ortsbestimmung des Smartphones (z.B. per GPS-Ortung) wird die aktuelle geografische Position der Einrichtung 17 bzw. der Verteilerstation bestimmt (Schritt 41) und als Ortsinformation erfasst. Alternativ oder zusätzlich kann auch eine Bestimmung der topologischen Position der Einrichtung 17 erfolgen.

Die Ortsinformation wird zusammen mit der Identifikationsinformation an ein übergeordnetes Überwachungssystem übertragen (Schritt 42).

Im übergeordneten Überwachungssystem werden die Identifikationsinformation und die Ortsinformation abgespeichert und die Einrichtung mit ihrer Identifikationsinformation und der Ortsinformation im System angemeldet und aktiviert (Schritt 44) .

Wenn einem Meldesignal der Einrichtung 17 die Identifikationsinformation bei der Übertragung an das übergeordnete Überwachungssystem beigefügt wird, kann nach der Anmeldung und Aktivierung eine eindeutige Zuordnung von Meldesignalen der Einrichtung 17 zu der fraglichen Verteilerstation erfolgen. Zudem kann die geografische und/oder topologische Position der Einrichtung bzw. der Verteilerstation angegeben werden. Eine Darstellung in einem Kartendienst ist somit einfach möglich. Eine Datenmodellierung des Mittel- bzw. Niederspannungsnetzes ist dabei nicht erforderlich.

Durch die Verwendung der Einrichtung 17 können folgende Vorteile erreicht werden:
Die Einrichtung 17 erlaubt eine unmittelbare Erkennung und Lokalisierung einer ausgelösten Unterbrechungseinheit. Es ist nicht mehr notwendig, auf die Anrufe der Netzkunden zu warten (Erkennung) und die Verteilerstationen abzufahren (Lokalisierung). Damit können Pönalen und Serviceaufwände reduziert werden.

Die Einrichtung 17 kann sehr klein ausgeführt werden und damit sehr einfach in schon existierende Verteilerstationen, insbesondere Kabelverteilerschränke mit begrenztem Raumangebot, eingebaut werden. Der Netzbetreiber ist also nicht gezwungen, die Verteilerstation umzubauen. Es fallen keine hohen Umbaukosten für Umrüstung bzw. die Demontage der alten und die Montage der neuen Verteilerstation an.

Die Einrichtung kann gefahrlos im laufenden Betrieb montiert werden. Die Versorgung der an der Verteilerstation angeschlossenen Kunden muss nicht unterbrochen werden.

Die Einrichtung benötigt lediglich zwei externe Anschlüsse, nämlich einen Anschluss zur Stromversorgung und einen Anschluss für die externe Antenne der Mobilfunkeinheit. Dies reduziert den konstruktiven Aufwand und damit die Gerätekosten. In Verteilerstationen, die aus funkdurchlässigem Material, z.B. Kabelverteilerschränke aus glasfaserverstärkten Polyester, gefertigt sind, kann ggf. die Funkantenne in das Gerät integriert werden, so dass auf eine Außenantenne verzichtet werden kann. Neben dem einfacheren Aufbau kann damit auch die Anfälligkeit gegen Vandalismus verringert werden.

Die Einrichtung kann so ausgestaltet werden, dass die Auswerteeinheit mit einem sehr geringen Stromverbrauch auskommt. Dies erlaubt es, auf eine externe Stromversorgung zu verzichten und die Einrichtung mit einer Batterie zu versorgen. Damit reduziert sich die Montagezeit für die Einrichtung weiter.

Bei der Ausführungsform ohne externe Sensoren ergibt sich ein weiterer Kostenvorteil (keine externen Sensoren, keine Verkabelung und Anschlüsse).

Die Einrichtung funktioniert mit üblichen Sicherungseinsätzen und Sicherungsleisten, die in Kabelverteilerschränken oder Ortsnetzstationen eingebaut sind. Es ist nicht nötig, die Verteilerstation umzubauen.

Die Einrichtung kann einfach und durch den Einsatz von elektronischen Standardbauteilen günstig gefertigt werden.

Die Einrichtung kann so ausgestaltet werden, dass sie ihre Daten entweder ohne manuelle Konfiguration an einen Clouddienst sendet oder über ein Standardprotokoll an ein zentrales Netzleitsystem übermittelt.

Obwohl die Erfindung vorstehend im Detail durch bevorzugte Ausführungsbeispiele näher illustriert und beschrieben worden ist, ist die Erfindung nicht durch die offenbarten Beispiele eingeschränkt und andere Variationen können vom Fachmann hieraus abgeleitet werden, ohne den Schutzumfang der nachfolgenden Patentansprüche zu verlassen.

## Patentansprüche

1. Einrichtung (17) zur Überwachung einer Unterbrechungseinheit (16a, 16b, 16c) in einem elektrischen Energieversorgungsnetz,
**dadurch gekennzeichnet, dass**
- die Einrichtung (17) eine Sensorschnittstelle (21a) zum Anschluss einer Sensoreinheit (21b) zur Erfassung einer für die Unterbrechereinheit (16a, 16b, 16c) spezifischen Messgröße (M) aufweist;
- die Einrichtung (17) eine mit der Sensorschnittstelle (21a) in Verbindung stehende Auswerteeinheit (20) aufweist, die zur Erkennung einer Stromänderung hinsichtlich des durch die Unterbrechungseinheit (16a, 16b, 16c) fließenden Stroms anhand der Messgröße (M) eingerichtet ist; und
- die Einrichtung (17) eine mit der Auswerteeinheit (20) in Verbindung stehende Kommunikationsschnittstelle (22a) aufweist, über die im Falle einer erkannten Stromänderung ein Meldesignal (S), das auf einen kritischen Zustand der Unterbrechereinheit hinweist, an eine Kommunikationseinheit (22b) abgebbar ist.

2. Einrichtung (17) nach Anspruch 1,
**dadurch gekennzeichnet, dass**
- mit der Sensorschnittstelle (22a) eine Sensoreinheit (22b) zur Erfassung der Messgröße (M) verbunden ist; und
- die Auswerteeinheit (20) und die Sensoreinheit (22b) in einem gemeinsamen Gehäuse (31) angeordnet sind.

3. Einrichtung (17) nach Anspruch 1 oder 2,
**dadurch gekennzeichnet, dass** die Sensoreinheit (21b) einen Hall-Sensor umfasst.

4. Einrichtung (17) nach Anspruch 1 oder 2,
**dadurch gekennzeichnet, dass** die Sensoreinheit (21b) einen Stromsensor umfasst.

5. Einrichtung (17) nach einem der vorangehenden Ansprüche, **dadurch gekennzeichnet, dass**
- mit der Kommunikationsschnittstelle (22a) eine Kommunikationseinheit (22b) verbunden ist; und
- die Auswerteeinheit (20) und die Kommunikationseinheit (22b) in einem gemeinsamen Gehäuse (31) angeordnet sind.

6. Einrichtung (17) nach einem der vorangehenden Ansprüche,
**dadurch gekennzeichnet, dass** die Kommunikationseinheit (22b) ein Funkmodul ist.

7. Einrichtung (17) nach Anspruch 6,
**dadurch gekennzeichnet, dass** die Einrichtung (17) einen Anschluss zur Verbindung mit einer Funkantenne (22c) aufweist.

8. Einrichtung (17) nach einem der vorangehenden Ansprüche,
**dadurch gekennzeichnet, dass** die Einrichtung (17) mit einem maschinenlesbaren Code versehen ist, der eine eindeutige Identifizierung der Einrichtung (17) angibt.

9. Verfahren zum Überwachen einer Unterbrechungseinheit (16a, 16b, 16c) in einem elektrischen Energieversorgungsnetz mit einer Einrichtung (17) gemäß einem der Ansprüche 1 bis 8, bei dem
- mit einer der Einrichtung (17) zugeordneten Sensoreinheit (21b) eine für die Unterbrechungseinheit (16a, 16b, 16c) spezifische Messgröße (M) erfasst wird;
- mit einer Auswerteeinheit (20) der Einrichtung (17) die Messgröße (M) hinsichtlich des Auftretens einer Stromänderung des durch die Unterbrechungseinheit (16a, 16b, 16c) fließenden Stroms untersucht wird; und
- bei vorliegender Stromänderung mittels einer der Einrichtung (17) zugeordneten Kommunikationseinheit (22b) ein Meldesignal (M) abgegeben wird, das auf einen kritischen Zustand der Unterbrechungseinheit (16a, 16b, 16c) hinweist.

10. Verfahren nach Anspruch 9,
**dadurch gekennzeichnet, dass** vor der Inbetriebnahme die Einrichtung (17) diese in einer Verteilerstation (10) montiert wird.

11. Verfahren nach Anspruch 10,
**dadurch gekennzeichnet, dass** bei der Montage ein maschinenlesbarer Code erfasst wird, der eine Identifizierungsinformationen enthält, die eine eindeutige Identifizierung der Einrichtung (17) ermöglicht.

12. Verfahren nach Anspruch 11,
**dadurch gekennzeichnet, dass** der Identifizierungsinformation eine Ortsinformation zugeordnet wird, die den geografischen und/oder topologischen Ort der Verteilerstation (10) angibt.

13. Verteilerstation (10) mit einer überwachten Unterbrechungseinheit (16a, 16b, 16c) und einer Einrichtung (17) nach einem der Ansprüche 1 bis 8.

14. Verteilerstation (10) nach Anspruch 13,
**dadurch gekennzeichnet, dass** in der Verteilerstation (10) eine Mehrzahl von Unterbrechungseinheiten (16a, 16b, 16c) und eine einzige Einrichtung (17) zur Überwachung der Mehrzahl von Unterbrechungseinheiten (16a, 16b, 16c) angeordnet sind.

15. Verteilerstation (10) nach Anspruch 13 oder 14,
**dadurch gekennzeichnet, dass** die Unterbrechungseinheit (16a, 16b, 16c) eine Schmelzsicherung oder ein elektromechanisch auslösender Schalter ist.
